**Europäisches Patentamt**

**European Patent Office**

**Office européen des brevets**

(11) Veröffentlichungsnummer: **0 103 207**
**B1**

(12) # EUROPÄISCHE PATENTSCHRIFT

(45) Veröffentlichungstag der Patentschrift:
14.06.89

(51) Int. Cl.⁴: **H 03 B 9/14**

(21) Anmeldenummer: 83108147.6

(22) Anmeldetag: 17.08.83

(54) In Flossenleitungstechnik realisierter Oszillator.

(30) Priorität: 19.08.82 DE 3230831

(43) Veröffentlichungstag der Anmeldung:
21.03.84 Patentblatt 84/12

(45) Bekanntmachung des Hinweises auf die Patenterteilung:
14.06.89 Patentblatt 89/24

(84) Benannte Vertragsstaaten:
DE FR GB IT NL SE

(56) Entgegenhaltungen:
EP-A- 0 101 611
DE-A- 2 755 655
FR-A- 2 254 889

12th EUROPEAN MICROWAVE CONFERENCE, 13.-17. September 1982, Helsinki, FI, Seiten 702-706, Microwave Exhibitions and Publishers Ltd., Tunbridge Wells, Kent, GB; E. KPODZO u.a.: "Integrated fin-line MM-wave transceiver"
7th EUROPEAN MICROWAVE CONFERENCE, 5.-8. September 1977, Kopenhagen, DK, Seiten 593-597, Microwave Exhibitions and Publishers, Ltd., Sevenoaks, Kent, GB; R. KNÖCHEL u.a.: "A prototype oscillator

(73) Patentinhaber: ALCATEL N.V.,
Strawinskylaan 537 (World Trade Center), NL-1077 XX Amsterdam (NL)

(84) Benannte Vertragsstaaten: FR GB IT NL SE

(73) Patentinhaber: Standard Elektrik Lorenz Aktiengesellschaft, Hellmuth-Hirth-Strasse 42, D-7000 Stuttgart 40 (DE)

(84) Benannte Vertragsstaaten: DE

(72) Erfinder: Szabo, Laszlo, Dr.-Ing., Tubizer Strasse 11, D-7015 Korntal (DE)
Erfinder: Schünemann, Klaus, Prof. Dr.-Ing., Starenweg 79, D-3300 Braunschweig (DE)

(74) Vertreter: Schmidt, Werner, Dipl.-Phys. et al, Standard Elektrik Lorenz AG Patent- und Lizenzwesen Postfach 30 09 29, D-7000 Stuttgart 30 (DE)

(56) Entgegenhaltungen: (Fortsetzung)
circuit utilizing evanescent mode resonators"
10th EUROPEAN MICROWAVE CONFERENCE, 8.-12. September 1980, Warschau, PL, Seiten 750-753, Microwave Exhibitions and Publishers, Ltd., Sevenoaks, Kent, GB; G. BEGEMANN u.a.: "A Ku-band fin-line front-end with a hybrid-coupled balanced mixer and a gunn oscillator"
IEE JOURNAL ON MICROWAVES, OPTICS AND ACOUSTICS, Band 3, Nr. 3, Mai 1979, Seiten 115-120, Hitchin, GB; R. KNÖCHEL: "Design and performance of microwave oscillators in integrated fin-line technique"

## Beschreibung

Die Erfindung geht aus von einem in Flossenleitungstechnik realisierten Oszillator wie jeweils im Oberbegriff der Ansprüche 1 und 2 angegeben.

Ein solcher Oszillator ist aus dem Aufsatz «Design and Performance of Microwave Oscillators in Integrated Fin-Line Technique» von Knöchel in IEE Journal MOA, Bd. 3 (1979) Seiten 115–120 bekannt.

Dort ist das Gehäuse der als aktives Element verwendeten Diode mit seiner Längsachse parallel zu den metallischen Flossen der Flossenleitung angeordnet. Die Stirnfläche des Gehäuses muß hierbei entweder direkt auf eine metallische Flosse gelötet werden oder durch Dazwischenfügen eines federnden, metallischen Streifens mit der Flosse verbunden werden.

Nachteilig hierbei ist, daß der metallische Kontakt zum Diodengehäuse sehr sorgfältig herzustellen und eine Serienfertigung nur sehr aufwendig zu realisieren ist.

Bei den Oszillatoren gemäß den Ansprüchen 1 und 2 ist das Diodengehäuse jeweils auf einfache Weise gehaltert. Diese Lösungen eignen sich besonders für eine Serienproduktion. Es ist eine gute Anpassung an die Impedanz der Last möglich. Die Teile der Anordnung, die die Frequenz bestimmen, können bei der Schaltungsauslegung leicht entsprechend den jeweiligen Forderungen realisiert werden.

Bei allen Ausführungsbeispielen werden zur Ableitung der im Betrieb erzeugten Wärme durch die gewählten Halterungen des Diodengehäuses gute Wärmesenken gebildet.

Die Erfindung wird anhand der Zeichnungen beispielsweise näher erläutert. Es zeigt:

Fig. 1a einen Querschnitt durch ein erstes Ausführungsbeispiel,

Fig. 1b eine Draufsicht auf das erste Ausführungsbeispiel, und

Fig. 2 schematische Darstellungen weiterer Ausführungsbeispiele.

Flossenleitungen an sich sind allgemein bekannt. Sie weisen im Inneren eines Hohlleiters ein dielektrisches Substrat auf, auf das metallische Flossen so aufgebracht sind, daß zwischen ihnen ein Schlitz gebildet wird. Es gibt verschiedene Arten von Flossenleitungen, die sich im wesentlichen durch unterschiedliche Anordnungen der Flossen unterscheiden.

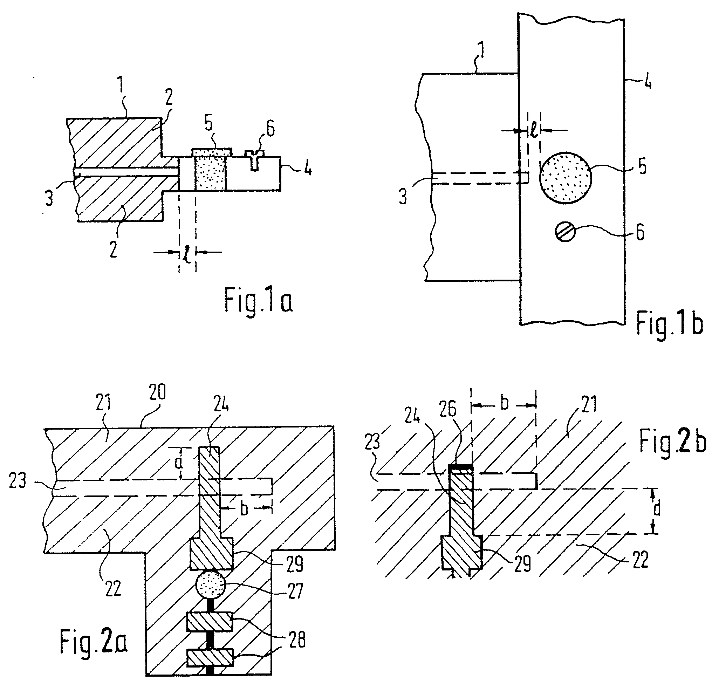

Im Querschnitt der Fig. 1a sind im linken Teil das Hohlleitergehäuse 1 der Flossenleitung sowie die auf das Substrat aufgebrachte Flossen 2 dargestellt. Die Flossen lassen auf dem Substrat einen Schlitz 3 frei. Mit dem Hohlleitergehäuse 1 der Flossenleitung ist ein Sperrbereichshohlleiter 4 verbunden. Sperrbereichshohlleiter sind Hohlleiter, die in ihrem Sperrbereich betrieben werden, d.h. der Querschnitt des Hohlleiters ist so gewählt, daß die Grenzfrequenz der Grundwelle des Hohlleiters oberhalb der gewünschten Frequenz des Oszillators liegt. Die Flossen 2 ragen ein kleines Stück in den Sperrbereichshohlleiter hinein.

Das Diodengehäuse 5, in dem sich die Diode befindet, ist in an sich bekannter Weise in dem Sperrbereichshohlleiter angeordnet. Zur Realisierung einer bestimmten Kapazität ist im Sperrbereichshohlleiter 4 weiterhin eine Abstimmschraube 6 vorgesehen, die zusammen mit dem Gehäuse eine definierte Kapazität bildet.

Als Flossenleitung ist beim Ausführungsbeispiel eine unilaterale Flossenleitung gewählt. Der Schlitz liegt symmetrisch zwischen den Flossen. Es sind jedoch auch andere Flossenleitungen verwendbar, z.B. eine Flossenleitung, bei der der Schlitz durch nur eine Flosse und die Gehäusewand gebildet wird.

In der Fig. 1b ist eine Draufsicht auf diese Anordnung dargestellt. Die Bezugszeichen sind wie in Fig. 1a gewählt.

Nachfolgend wird kurz die Funktionsweise näher erläutert:

Der Sperrbereichshohlleiter ist im Ersatzschaltbild durch eine reine Induktivität darzustellen. Daher kann durch den Einbau des aktiven Elements kein unerwünschter Resonanzeffekt entstehen. Im Bereich des Sperrbereichshohlleiters gibt es keine Wellenausbreitung, so daß die Ersatzinduktivität als ein konzentriertes Schaltelement betrachtet werden kann. Man wählt die Breite des Sperrbereichshohlleiters so, daß die gewünschte Oszillationsfrequenz etwa ⅔ oder weniger der Grundfrequenz der Grundwelle beträgt. Dann ist die Ersatzinduktivität des Sperrbereichshohlleiters auch nahezu frequenzunabhängig.

Um die gewünschte Frequenz zu erzeugen, ist der komplementäre Energiespeicher, also eine Kapazität, hinzuzufügen. Dies gechieht bei diesem Ausführungsbeispiel auf zweierlei Weise: Einmal stellt die Auskoppelstelle, d.h. der Sprung von dem Flossenleitungsschlitz auf den Sperrbereichshohlleiter, im Ersatzschaltbild eine Parallelkapazität dar. Diese Kapazität ist jedoch recht klein, da die metallischen Flossen sehr dünn (ca. 17,5 µm bis ca. 35 µm) sind. Damit läßt sich die induktive Reaktanz des Sperrbereichshohlleiters noch nicht kompensieren. Das geschieht durch eine weitere, größere Kapazität, die durch die Abstimmschraube im Sperrbereichshohlleiter realisiert wird. Damit kann zugleich die Frequenz des Oszillators mechanisch verändert werden. Der Sperrbereichshohlleiter muß in seinem rechten Bereich nicht unbedingt metallisch verschlossen sein, da hier nur aperiodisch gedämpfte Feldtypen existieren können.

Nachdem oben beschrieben wurde, wie die Frequenz eingestellt wird, wird nachfolgend beschrieben, wie Abstimmung auf die Last erfolgt. Hierzu muß der negative Ersatzwiderstand des aktiven Elements an den Verbraucher angepaßt werden. Als Freiheitsgrade bleiben einerseits die Schlitzbreite der Flossenleitung und andererseits der Abstand 1 zwischen dem Ende der Flossenleitung und dem Gehäuse des aktiven Elements übrig. Damit ist in jedem Fall eine eindeutige Anpassung möglich.

Die Versorgungsspannung für die Diode kann entweder in an sich bekannter Weise durch ein koaxiales Tiefpaßfilter zugeführt werden, oder aber – und diese Lösung ist der Struktur sehr gut angepaßt – durch einen dünnen Draht, der vom offenen Ende des Sperrbereichshohlleiters zur Diode geführt wird. Man muß dann dieses offene Ende nur mit dampfendem Material zustopfen, damit hier keine Hochfrequenzleistung entweichen kann. Durch diese Maßnahme verringert sich die Ausgangsleistung nur unwesentlich (typisch um 0,2 dB), während man jedoch zwei weitere Vorteile gewinnt: Einmal wird die Anschwingsicherheit vergrößert, zum anderen der harmonische Gehalt des Ausgangsspektrums um typisch 10 dB abgesenkt. Wünscht man keine mechanische Durchstimmbarkeit des Oszillators, so kann die Abstimmschraube in einer Modifikation der Schaltung auch durch einen metallischen Streifen ersetzt werden, der durch Fotoätztechnik auf einem dielektrischen Substratmaterial erzeugt wird. Dazu hat man sich in Fig. 1a vorzustellen, daß das dielektrische Substrat, auf das im linken Teil die Flossen aufgebracht sind, sich auch rechts des aktiven Elementes befindet. Man kann dann auf der Kupferkaschierung dieses Substrates durch Ätzen einen longitudinalen, metallischen Streifen stehen lassen, der bei geeigneter Bemessung der Länge so wie der Höhe eine Kapazität darstellt. Auf diese Weise hat man eine rein planare Struktur realisiert und dabei die Diode billig, reproduzierbar und mit guter Wärmesenke eingebaut.

Man kann den Oszillator in vorteilhafter Weise durch Hinzufügen einer Varaktordiode zu einer elektronisch durchstimmbaren Komponente ergänzen. Dazu gibt es zwei Möglichkeiten: Einmal kann die Varaktordiode in einem normalen Gehäuse (z.B. S4-Gehäuse) in den Sperrbereichshohlleiter anstelle oder zusätzlich zur Abstimmschraube eingebaut werden. Die Halterung gleicht damit der des aktiven Elementes. Eine zweite Möglichkeit ist die, eine Varaktordiode in einem beam-lead Gehäuse an geeigneter Stelle direkt über den Flossenleitungs-Schlitz zu bonden. Man kann hier entlang des Schlitzes Orte finden, an denen die Varaktordiode so stark angekoppelt ist, daß der elektronische Durchstimmbereich Prozente beträgt. Dann verringert sich allerdings auch die Ausgangsleistung um 1 bis 3 dB. An anderen Orten ist dagegen die Ankopplung nur schwach, so daß man praktisch ohne Einbuße an Ausgangsleistung einen Durchstimmbereich in der Größenordnung von 3% bezogen auf die Nennfrequenz, realisieren kann.

Anhand der Fig. 2a wird ein weiteres Ausführungsbeispiel erläutert. Hier ist das Diodengehäuse nicht in einem Hohlleiter sondern in dem Substrat, auf das die Flossen der Flossenleitung aufgebracht sind, befestigt.

Bei der schematischen Darstellung in der Fig. 2a sind auf der Ober- und der Unterseite eines (nicht dargestellten) dielektrischen Substrates Metallisierungen aufgebracht. Metallisierungen auf der Substratunterseite sind durch eine Schraffur von links unten nach rechts oben, solche auf der Substratoberseite durch eine Schraffur von links oben nach rechts unten gekennzeichnet.

Die Flossen 21, 22 der Flossenleitung bilden auf der Substratunterseite einen Schlitz 23. Das Substrat und die Flossen befinden sich in einem Hohlleiter 20.

Auf der anderen Seite des Substrats und senkrecht zur Schlitzrichtung ist ein Streifenleiter 24 auf das Substrat aufgebracht, der um eine Länge a über den Schlitz hinausragt. Der Abstand des Streifenleiters vom Schlitzende ist b.

Das Diodengehäuse 27 ist in einer Bohrung im Substrat befestigt und mit dem Streifenleiter 24 leitend verbunden. Die Versorgungsspannung für die Diode wird über ein in Streifenleitungstechnik realisiertes Tiefpaßfilter 28 zugeführt.

Bei dieser Anordnung wird die Streifenleitung mit der Flossenleitung über einen Streifen-Schlitzübergang verkoppelt. Dieser Übergang stellt bei einer geeigneten Wahl der Längen a und b einen Resonanzkreis dar, der die Frequenz bestimmt. Die Anpassung des Realteils der Diodenimpedanz geschieht durch die Wahl des Wellenwiderstands der Flossenleitung, d.h. durch eine geeignete Wahl der Schlitzweite, sowie durch einen Viertelwellenlängen-Transformator 29 auf der Streifenleitung direkt vor der Diode. Auf diese Weise kann bei einer durch a und b bestimmten Frequenz die Nennleistung des aktiven Elements ausgekoppelt werden.

Eine Weiterbildung dieser Lösung ist in Figur 2b dargestellt.

Bei der Anordnung nach Fig. 2b wird die Länge a sehr klein gewählt und die Streifenleitung wird mittels Durchkontaktieren 26 mit der metallischen Flosse 21 auf der anderen Substratseite verbunden. In diesem Fall wird der Resonanzkreis, der die Frequenz bestimmt, durch eine geeignete Wahl der Länge b (Abstand des Streifenleiters vom Schlitzende) sowie durch den Abstand d des Viertelwellenlängen-Transformators 29 vom Flossenleitungsschlitz 23 bestimmt. Die Anpassung des Realteils der Diodenimpedanz an die Last erfolgt wie beim Ausführungsbeispiel gemäß Fig. 2a.

Abschließend sollen einige Bemerkungen zum Betriebsverhalten gemacht werden. Mit allen Strukturen ist es möglich, die Nennleistung der Diode auszukoppeln. Der externe Gütefaktor und damit die Bandbreite sind vergleichbar mit den Werten, die in reiner Hohlleitertechnik erreicht werden. Damit liegt auch das Rauschen ähnlich niedrig. Der elektronische Durchstimmbereich der ersten Struktur beträgt typisch 5 bis 10%.

Es wurde jeweils angegeben, welche Parameter einen Schwingkreis bilden bzw. die Frequenz festlegen und welche Parameter zur Anpassung an die Last geeignet bemessen werden müssen. Mit diesem Wissen ist es fachmännisches Können, die tatsächlichen Längen für einen konkreten Fall zu bestimmen. Deshalb wird hierauf nicht näher eingegangen.

**Patentansprüche**

1. In Flossenleitungstechnik realisierter Oszillator mit einer in einem Gehäuse (5) angeordneten Diode als aktivem Element und einem Impedanztransformationsnetzwerk zur Anpassung der Diode an eine Last und zur Bestimmung der Frequenz, dadurch gekennzeichnet, daß der Hohlleiter (1) der Flossenleitung mit einem Sperrbereichshohlleiter (4) verbunen ist, daß die Flossen (2) der Flossenleitung in den Sperrbereichshohlleiter (4) hineinragen, daß das Diodengehäuse (5) im Sperrbereichshohlleiter angeordnet und mit der Ober- oder Unterseite des Sperrbereichshohlleiters leitend verbunden ist, und daß zur Festlegung der Frequenz und zur Anpassung der Diode an die Last der Abstand (l) zwischen Flossenende und Diodengehäuse und/oder die Breite des Schlitzes zwischen den Flossen sowie die Kapazität im Sperrbereichshohlleiter entsprechend gewählt sind.

2. In Flossenleitungstechnik realisierter Oszillator mit einer in einem Gehäuse (27) angeordneten Diode als aktivem Element und einem Impedanztransformationsnetzwerk zur Anpassung der Diode an eine Last und zur Bestimmung der Frequenz, dadurch gekennzeichnet, daß das Diodengehäuse (27) in dem Substrat, auf dem die Flossen (21, 22) der Flossenleitung aufgebracht sind, befestigt ist, daß auf der den Flossen gegenüberliegenden Seite des Substrats und angenähert senkrecht zu dem von den Flossen gebildeten Schlitz (23) der Flossenleitung eine Streifenleitung (24) aufgebracht ist, und daß das Diodengehäuse (27) mit dem Streifenleiter (24) leitend verbunden ist.

3. Oszillator nach Anspruch 2, dadurch gekennzeichnet, daß der Streifenleiter (24, Fig. 2b) gerade soweit über den Schlitz (23) der Flossenleitung hinausragt, daß der Streifenleiter (24, 26) mit der Flosse (21) auf der gegenüberliegenden Substratseite leitend verbindbar ist und daß diese Verbindung (26) vorhanden ist, daß die Streifenleitung in einem bestimmten Abstand (d) vom Schlitz (23) zu einem Viertelwellenlängen-Transformator (29) ausgebildet ist, und daß dieser bestimmte Abstand (d), der Abstand (b) der Streifenleitung (24) vom Schlitzende und die Schlitzbreite der Flossenleitung entsprechend der gewünschten Frequenz und der Impedanz der Last gewählt sind.

4. Oszillator nach Anspruch 2, dadurch gekennzeichnet, daß der Streifenleiter (24, Fig. 2a) um ein bestimmtes Stück (a) über den Schlitz (23) hinausragt und daß die Länge dieses Stücks (a), der Abstand (b) der Streifenleitung vom Schlitzende und die Schlitzbreite der Flossenleitung entsprechend der gewünschten Frequenz und der Impedanz der Last gewählt sind.

## Claims

1. Fin-line oscillator comprising a diode as an active element, which is housed in a package (5), and an impedance-matching network for matching the diode to a load and determining the frequency, characterized in that the waveguide (1) containing the fin line is connected with a cutoff waveguide (4), that the fins (2) of the fin line extend into the cutoff waveguide (4), that the diode package (5) is disposed in the cutoff waveguide and electrically connected to the top or bottom side of the cutoff waveguide, and that a suitable distance (l) between the fin ends and the diode package and/or a suitable width of the slot between the fins as well as a suitable value of the capacitance in the cutoff waveguide are chosen to determine the frequency and match the diode to the load.

2. Fin-line oscillator comprising a diode as an active element, which is housed in a package (27), and an impedance-matching network for matching the diode to a load and determining the frequency, characterized in that the diode package (27) is mounted in the substrate on which the fins (21, 22) of the fin line are deposited, that a stripline (24) is deposited on the side of the substrate opposite the fins and at approximately right angles to the slot (23) formed by the fins, and that the diode package (27) is electrically connected to the stripline (24).

3. An oscillator as claimed in claim 2, characterized in that the stripline (24, Fig. 2b) extends beyond the slot (23) of the fin line to the point that the stripline (24, 26) is electrically connectable to the fin (21) on the opposite side of the substrate, that this connection (26) is made, that at a given distance (d) from the slot (23), the stripline forms a quarter-wave transformer (29), and that this given distance (d), the distance (b) of the stripline (24) from the end of the slot, and the slot width of the fin line are chosen in accordance with the desired frequency and the impedance of the load.

4. An oscillator as claimed in claim 2, characterized in that the stripline (24, Fig. 2a) extends a given distance (a) beyond the slot (23), and that this given distance (a), the distance (b) of the stripline from the end of the slot, and the slot width of the fin line are chosen in accordance with the desired frequency and the impedance of the load.

## Revendications

1. Oscillateur réalisé selon la technique des lignes à fente, comprenant une diode comme élément actif, disposée dans un boîtier (5), et un réseau de transformation d'impédance, pour l'adaption de la diode à une charge et la détermination de la fréquence, caractérisé en ce que le guide d'onde (1) de la ligne à fente est connecté à un guide d'onde de coupure (4), en ce que l'ailette (2) de la ligne à fente s'étend dans le guide d'onde de coupure (4), en ce que le boîtier (5) de la diode est disposé dans le guide d'onde de coupure et est électriquement connecté à la face supérieure ou inférieure du guide d'onde de coupure, et en ce que la distance (2) entre les extrémités d'ailette et le boîtier de diode et/ou la largeur de la fente entre ailettes, de même que la capacitance du guide d'onde de coupure, sont choisies de manière appropriée pour les besoins de la determination de la fréquence et de l'adaptation de la diode.

2. Oscillateur réalisé selon la technique des lignes à fente, comprenant une diode comme élément actif, disposée dans un boîtier (27), et un réseau de transformation d'impédance, pour l'adaptation de la diode à une charge et la détermination de la fréquence, caractérisé en ce que le boîtier de diode (27) est monté dans le substrat sur lequel sont déposées les ailettes (21, 22) de la ligne à fente, en ce qu'une ligne en bande (24) est déposée sur le côté du substrat opposé aux ailettes et approximativement à angle droit avec la fente (23) formé par les ailettes, et en ce que le boîtier de diode est électriquement connecté à la ligne en bande.

3. Oscillateur conforme à la revendication 2, caractérisé en ce que la ligne en bande (24, fig. 2b) s'étend au-delà de la fente (23) de la ligne à fente (21), assez loin pour que la ligne en bande (24, 26) puisse être connectée à l'ailette (21), du côté opposé du substrat, en ce que cette connexion est réalisée, en ce que, à une distance donnée (d) de la fente (23), la ligne en bande forme un transformateur en quart d'onde (29), et en ce que ladite distance donnée (d), la distance (b) entre la ligne en bande (24) et l'extrémité de la fente et la largeur de la fente de la ligne à fente sont choisies en fonction de la fréquence désirée et de l'impédance de la charge.

4. Oscillateur conforme à la revendication 2, caractérisé en ce que la ligne en bande (24, fig. 2) s'étend jusqu'à une distance déterminée (a) au-delà de la fente (23) et en ce que cette distance déterminée (a), la distance (b) entre la ligne en bande et l'extrémité de la fente et la largeur de la fente sont choisies en fonction de la fréquence désirée et de l'impédance de la charge.

Fig.1a

Fig.1b

Fig.2a

Fig.2b